Europäisches Patentamt

European Patent Office

Office européen des brevets

(11) Veröffentlichungsnummer: **0 368 133**

**A2**

(12) # EUROPÄISCHE PATENTANMELDUNG

(21) Anmeldenummer: **89120249.1**

(22) Anmeldetag: **02.11.89**

(51) Int. Cl.5: **H05K 7/20, H01L 25/11**

(30) Priorität: **05.11.88 DE 3837617**

(43) Veröffentlichungstag der Anmeldung:
**16.05.90 Patentblatt 90/20**

(84) Benannte Vertragsstaaten:
**CH DE FR GB IT LI SE**

(71) Anmelder: **SEMIKRON ELEKTRONIK GMBH**
**Sigmundstrasse 200 Postfach 82 02 51**
**D-8500 Nürnberg 82(DE)**

(72) Erfinder: **Augustin, Karl-Heinz**
**Oberfürberger Strasse 16**
**D-8510 Fürth(DE)**
Erfinder: **Schötz, Walter**
**Phillipstrasse 42**
**D-8500 Nürnberg 80(DE)**

(54) **Trägerkörper zur elektrisch isolierten Anordnung von Bauteilen.**

(57) Bei bekannten großflächigen Trägerkörpern mit einer metallischen Grundplatte und einer auf dieser durch Löten befestigten Isolierscheibe aus einer thermisch gut leitenden Keramik entsteht nach dem Lötprozeß zum Verbinden der beiden Materialien eine aufwendige Nacharbeit erfordernde Verwölbung der Grundplatte.

Der Trägerkörper nach der Erfindung zeigt die Verwölbung nicht, ermöglicht den Aufbau von beliebigen Bauteilstrukturen mit konstant wirtschaftlicher Herstellung, Verbesserung der Verlustwärmeableitung sowie optimale Flächennutzung der gesamten Isolierscheibe.

Der neue Trägerkörper weist eine in Stücke unterteilte Isolierscheibe auf, und die metallisierten Isolierscheibenstücke sind in gegenseitigem Abstand auf der Grundplatte befestigt und über leitfähige Überbrückungen galvanisch verbunden. Als solche sind die Metallisierungen der Isolierscheibenstücke entsprechend ausgebildet. Sie können aus Kupfer bestehen und durch Bonden aufgebracht sein. Die Isolierscheibenstücke können eine strukturierte Metallisierung tragen.

Der Trägerkörper betrifft alle Aufbauten mit potentialfreier Befestigung von Bauteilen.

## Trägerkörper zur elektrisch isolierten Anordnung von Bauteilen.

Die Erfindung betrifft einen Trägerkörper zur elektrisch isolierten Anordnung von Bauteilen nach dem Oberbegriff des Anspruchs 1.

Derartige Trägerkörper sind z.B. bei Anordnungen mit Verlustwärme erzeugenden Bauteilen auf einem Kühlkörper bekannt. Dabei besteht der Trägerkörper aus einer Grundplatte aus Kupfer und aus einer auf dieser durch Weichlöten befestigten Scheibe aus Keramik, z.B. aus Aluminiumoxid. Diese weist zumindest auf der freien Oberfläche eine Metallisierung auf, welche eine Verbindung der Bauteile mit dem Trägerkörper sowohl durch Löten als auch durch Druck z.B. mittels Federkraft ermöglicht.

Infolge der unterschiedlichen Wärmeausdehnungskoeffizienten von Kupfer und Keramik entsteht bereits beim Herstellen, d.h. beim Abkühlen nach dem Lötprozeß zum Verbinden der beiden Materialien, eine unerwünschte, bezüglich der Auflagefläche der Grundplatte konkave Verwölbung, deren Beseitigung aufwendige Nacharbeit erfordert. Dieser Nachteil kann nicht durch dickere Lotschichten oder durch besondere Formgebung der Grundplatte beseitigt werden, und eine beliebige Vergrößerung der Materialdicke der Grundplatte steht einem wirtschaftlichen Einsatz eines solchen Aufbaus entgegen.

Der Erfindung liegt die Aufgabe zugrunde, einen Trägerkörper anzugeben, bei welchem der genannte Nachteil vermieden wird, d.h. bei welchem eine Verwölbung als Folge einer Wärmebehandlung nicht eintritt.

Die Lösung der Aufgabe besteht bei einem Trägerkörper der eingangs genannten Art in den kennzeichnenden Merkmalen des Anspruchs 1. Vorteilhafte Ausgestaltungen der Erfindung sind in den Ansprüchen 2 bis 8 angegeben.

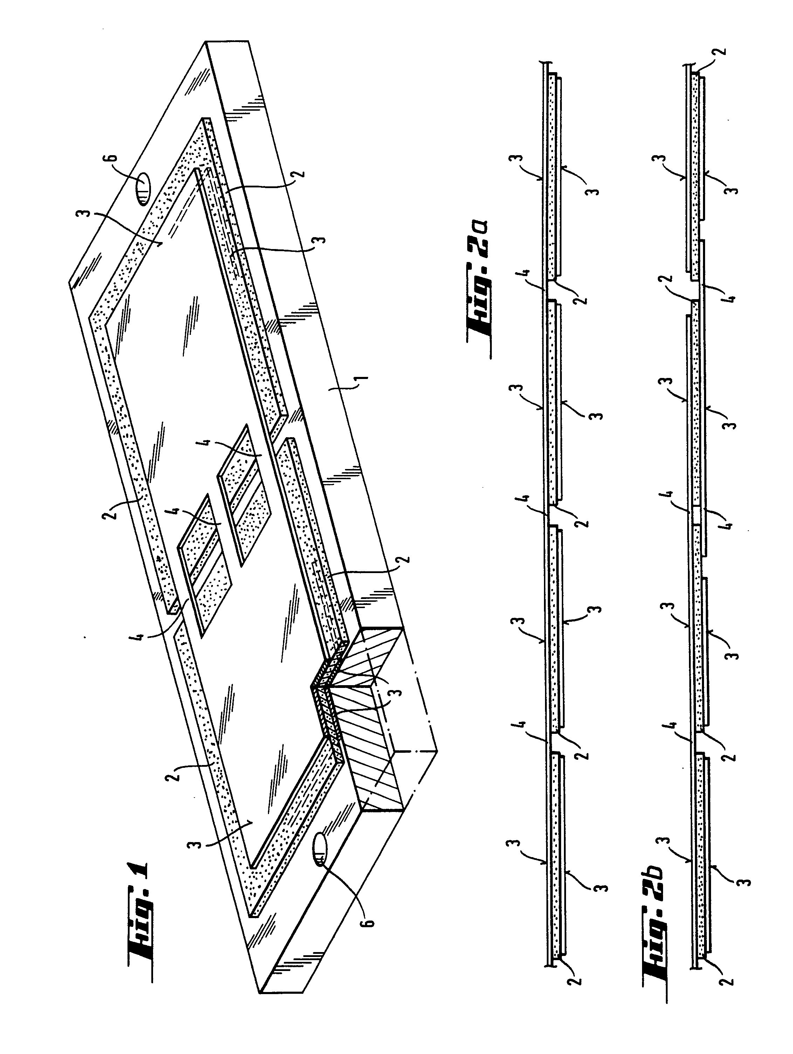

Anhand der Ausführungsbeispiele in der Zeichnung wird die Erfindung erläutert. Figur 1 zeigt perspektivisch und in teilweisem Schnittaufbruch einen Aufbau des Trägerkörpers, und in den Figuren 2a und 2b ist jeweils in Seitenansicht eine Aufreihung von mittels Metallisierung verbundenen Isolierscheibenstücken dargestellt. Für gleiche Teile sind in allen Figuren gleiche Bezeichnungen gewählt.

Bei einer Anordnung nach Figur 1 sind auf der Oberseite einer metallischen Grundplatte (1), die eine plane untere Fläche zur Auflage z.B. auf einem Kühlkörper aufweist, Isolierscheibenstücke (2) in gegenseitigem Abstand fest aufgebracht. Die Isolierscheibenstücke (2) bilden in entsprechender geometrischer Anordnung eine Isolierscheibe größerer Flächenausdehnung. Die Dicke der Isolierscheibenstücke (2) ist durch fertigungstechnische Möglichkeiten einerseits und durch eine vorgegebene Isolationsfestigkeit zwischen vorgesehenen Bauteilen und der im Einsatz z.B. auf Erdpotential befindlichen Grundplatte andererseits bestimmt, und sie sind an ihren beiden Kontaktflächen jeweils mit einer lötfähigen Metallisierung (3) versehen. Die Isolierscheibenstücke (2) bestehen vorzugsweise aus Keramik, z.B. aus Aluminiumoxid, Berylliumoxid oder Aluminiumnitrid. Die Metallisierung (3) ist bevorzugt eine in an sich bekannter Weise durch Bonden erzielte Kupferauflage. Insbesondere bei großflächigem Aufbau, welcher auf der Oberseite der Isolierscheibenstücke (2) mehrere, Verlustwärme erzeugende Bauelemente tragen kann, wird mit einer durch Ausbildung und vorgesehene gegenseitige Lage der Bauelemente bestimmten Struktur von Isolierscheibenstücken (2) gemäß der Erfindung eine Verwölbung der Grundplatte (1) vermieden. Die Isolierscheibenstücke sind durch Löten auf der Grundplatte (1) befestigt und in gegenseitigem Abstand über leitfähige Überbrückungen galvanisch verbunden. Die Überbrückungen können als zusätzliche flexible oder starre Teile jeweils mit einem Ende auf benachbarten Isolierscheibenstücken befestigt sein. Eine vorteilhafte Weiterbildung der Erfindung ist dadurch gegeben, daß als leitfähige Überbrückungen zur Verbindung der Isolierscheibenstücke die Metallisierung derselben vorgesehen ist. Die Metallisierungen (3) gemäß der Darstellung sind an der Oberseite der Isolierscheibenstücke über streifenförmige Leiterstege (4) verbunden. Diese können z.B. durch Maskieren und Herstellen von zwischenliegenden Öffnungen einer durchgehenden, ganzflächigen Metallauflage gebildet werden. Durch entsprechende Anzahl, Ausbildung und Lage solcher Leiterstege als leitfähige Überbrückungen zwischen Isolierscheibenstücken sind beliebige elektrische Verbindungen zwischen Bauteilstrukturen und damit über mehrere Isolierscheibenstücke sich erstreckende Anordnungen realisierbar.

Die Grundplatte (1) weist bevorzugt auf ihrer Oberseite einen die Lötverbindung mit der Keramik fördernden metallischen Überzug auf. Zum Verbinden der Bauteile Grundplatte (1) und Keramik können bekannte Weichlote aufZinn- oder Bleibasis mit Zusätzen zur Verbesserung einzelner anwendungsspezifischer Eigenschaften verwendet werden.

Die Dicke der Grundplatte (1) ist abhängig von der Flächenausdehnung der Keramik, und diese wiederum ist durch die gewünschte Bauteileanordnung und ihre Anwendung bestimmt.

In den Figuren 2a und 2b sind jeweils in einer Ebene in Reihe angeordnete Isolierscheibenstücke (2) dargestellt. Diese können in Länge und Breite unterschiedlich bemessen sein und sind gemäß Figur 2a an einer Seite mittels einer durchgehenden, aus Metallisierungen (3) und Leiterstegen (4) gebildeten Kontaktbahn verbunden. Senkrecht zur Zeichenebene können mehrere Kontaktbahnen bestehen. Der Abstand zwischen benachbarten Isolierscheibenstücken (2) ist nur durch die Forderung bestimmt, daß er bei jeder Art von Prozessen zur festen Verbindung der Isolierscheibenstücke mit der Grundplatte (1) über die Dicke der Isolierscheibenstücke erhalten bleiben muß. Die dargestellte Struktur erlaubt die Herstellung von Bauelementeanordnungen auf mehreren Isolierscheibenstücken mit durch Leiterstege (4) gebildeten Verbindungsleitern.

Bei der in Figur 2b gezeigten Reihe von Isolierscheibenstücken (2) sind die beiden mittleren beidseitig galvanisch verbunden, und das rechte, äußere Isolierscheibenstück ist an seiner Oberseite von den übrigen galvanisch getrennt. Die beliebige Ausdehnung der Metallisierung der Keramikunterseite gegenüber derjenigen der Oberseite ermöglicht eine Verbesserung der Verlustwärmeableitung durch Einbeziehen von an das jeweilige Isolierscheibenstück angrenzenden Abschnitten der Grundplatte. Beim Aufbringen der Isolierscheibenstücke in gegenseitigem Abstand auf die metallische Grundplatte (1) ist zu berücksichtigen, daß nach einem Temperaturprozeß und dem Abkühlen von Grundplatte und Isolierscheibenstücken durch das Schrumpfen der Materialien Veränderungen der Teileabstände entstehen können. Mit einem Abstand von wenigstens 0,5 mm nach dem Abkühlen wurden günstige Ergebnisse erzielt.

Weitere vorteilhafte Ausgestaltungen der Erfindung bestehen darin, daß die Isolierscheibenstücke (2) auf wenigstens einer Seite eine strukturierte, d.h. eine in schaltungsabhängig bemessene und angeordnete Bereiche unterteilte Metallisierung aufweisen, und/oder daß die Metallisierung der Isolierscheibenstücke als Teil eines Leiterbahnmusters zur Kontaktierung und Verbindung von Bauteilen einer Schaltung ausgebildet ist.

Die Vorteile der Erfindung bestehen in der optimalen Flächennutzung der oberseitigen Metallisierung (3, 13) der Isolierscheibenstücke (2) mit zusätzlicher Verwendung der leitfähigen Überbrückungen zwischen benachbarten Isolierscheibenstücken als Leiterstege, in der Verbesserung der Verlustwärmeableitung durch Erweiterung des entsprechenden Grundplattenbereiches mit Hilfe einer über das jeweilige Isolierscheibenstück hinausragenden unteren Metallisierung, und in konstant wirtschaftlicher Herstellung von Bauteilanordnungen mit beliebiger Flächenausdehnung.

**Ansprüche**

1. Trägerkörper zur elektrisch isolierten Anordnung von Bauteilen, bestehend aus einer metallischen Grundplatte und einer metallisierten, auf dieser durch Löten befestigten, thermisch gut leitenden Isolierscheibe,

**dadurch gekennzeichnet, daß**

die Isolierscheibe in Stücke (2) unterteilt ist, und daß die Isolierscheibenstücke (2) in gegenseitigem Abstand auf der Grundplatte (1) befestigt und über leitfähige Überbrückungen galvanisch verbunden sind.

2. Trägerkörper nach Anspruch 1, dadurch gekennzeichnet, daß als leitfähige Überbrückungen (4, 14) zur galvanischen Verbindung der Isolierscheibenstücke (2) die Metallisierung derselben vorgesehen ist.

3. Trägerkörper nach Anspruch 2, dadurch gekennzeichnet, daß die Isolierscheibenstücke (2) auf der Grundplatte (1) in einer Ebene angeordnet und wenigstens teilweise über eine durchgehend verlaufende Metallisierung (3, 13; 4, 14) galvanisch verbunden sind.

4. Trägerkörper nach Anspruch 3, dadurch gekennzeichnet, daß die Isolierscheibenstücke (2) eine gebondete Metallisierung (3, 13) aus Kupfer aufweisen.

5. Trägerkörper nach Anspruch 1 oder einem der folgenden Ansprüche, dadurch gekennzeichnet, daß die Isolierscheibenstücke (2) aus einer Keramik, vorzugsweise aus Aluminiumoxid oder Berylliumoxid oder aus Aluminiumnitrid bestehen.

6. Trägerkörper nach Anspruch 1 oder einem der folgenden Ansprüche, dadurch gekennzeichnet, daß die Grundplatte (1) aus Stromleitermaterial besteht, daß die Isolierscheibenstücke (2) gleiche Dicke aufweisen, und daß der jeweilige Abstand zwischen zwei benachbarten Isolierscheibenstücken (2) durch stegförmige Metallisierungsbereiche (4, 14) überbrückt ist.

7. Trägerkörper nach Anspruch 1 oder einem der folgenden Ansprüche, dadurch gekennzeichnet, daß die Isolierscheibenstücke (2) auf wenigstens einer Fläche eine strukturierte Metallisierung aufweisen.

8. Trägerkörper nach Anspruch 7, dadurch gekennzeichnet, daß die Metallisierung (3, 13) der Isolierscheibenstücke (2) als Teil einer Leiterbahnstruktur zum Verbinden von Bauteilen vorgesehen ist.

*Fig. 1*

*Fig. 2a*

*Fig. 2b*

EP 0 368 133 A2